Europäisches Patentamt

European Patent Office

Office européen des brevets

(11) Publication number: **0 670 632 A1**

# EUROPEAN PATENT APPLICATION

(21) Application number: **95102656.6**

(22) Date of filing: **24.02.95**

(51) Int. Cl.⁶: **H03K 3/03**, H03K 3/354, H03K 3/011

(30) Priority: **28.02.94 JP 29195/94**

(43) Date of publication of application:
**06.09.95 Bulletin 95/36**

(84) Designated Contracting States:
**DE FR GB**

(71) Applicant: **KABUSHIKI KAISHA TOSHIBA**
**72, Horikawa-cho,**
**Saiwai-ku**
**Kawasaki-shi,**
**Kanagawa-ken 210,**
**Tokyo (JP)**
Applicant: **TOSHIBA MICRO-ELECTRONICS**
**CORPORATION**
**25-1, Ekimaehoncho**
**Kawasaki-ku,**
**Kawasaki-shi (JP)**

(72) Inventor: **Morishita, Ken, c/o Intellectual Prop.**
**Div.**
**K.K. Toshiba,**
**1-1 Shibaura 1-chome**
**Minato-ku,**
**Tokyo 105 (JP)**
Inventor: **Takase, Hideki, c/o Intellectual Prop.**
**Div.**
**K.K. Toshiba,**
**1-1 Shibaura 1-chome**
**Minato-ku,**
**Tokyo 105 (JP)**

(74) Representative: **Lehn, Werner, Dipl.-Ing. et al**
**Hoffmann, Eitle & Partner,**
**Patentanwälte,**
**Arabellastrasse 4**
**D-81925 München (DE)**

(54) **Ring oscillation circuit.**

(57) k̲ number of CMOS inverters (11-1, 11-2, 11-3, 11-k (k = odd number)) are connected in a ring shape. Each of serial circuits (13) is connected between a connecting point of the respective CMOS inverters and a ground point. Each of the serial circuit (13) comprises one MOS transistor (N2, P2) and one capacitor (12) connected to each other in series. A voltage generation circuit (14) supplies a fixed voltage to a gate of one MOS transistor (N2, P2) of each of the serial circuit (13). The voltage generation circuit (14) comprises two resistor elements (R1, R2) connected in series to each other, and a power supply voltage is applied to one end of the resistor and a ground voltage is applied to the other end.

F I G. 2

EP 0 670 632 A1

The present invention relates to a ring oscillation circuit for supplying a high-frequency clock signal to a boosting circuit of an EEPROM.

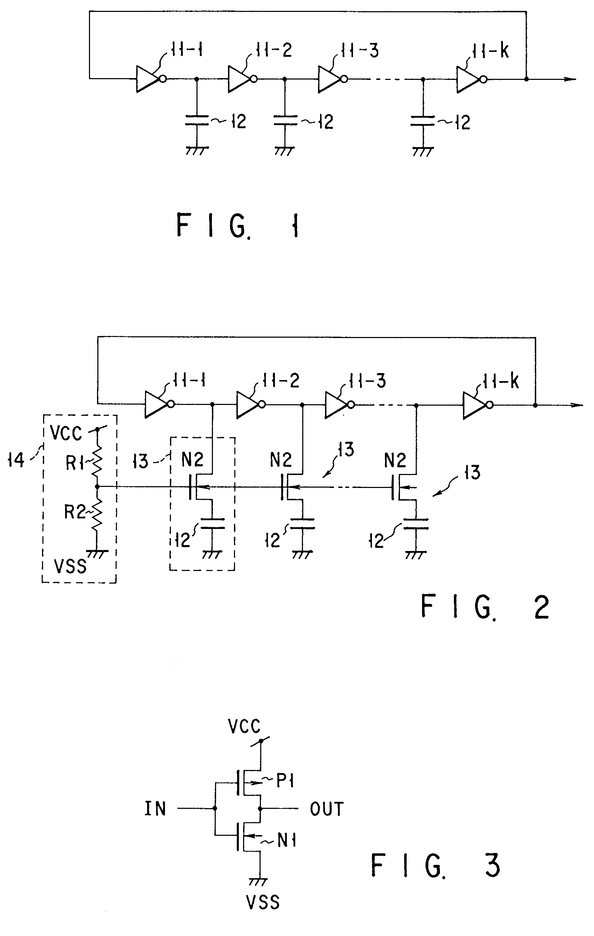

FIG. 1 shows a conventional ring oscillation circuit.

The ring oscillation circuit comprises $k$ number of CMOS inverters 11-1, 11-2, 11-3, 11-k ($k$ = odd number) connected in a ring shape, and a capacitor 12 connected between a connecting point of the respective CMOS inverters (excepting a connecting point between CMOS inverters 11-k and 11-1) and a ground point.

A clock signal is outputted from the CMOS inverter circuit 11-k. An oscillation frequency of the clock signal is determined by a time constant C × R wherein C = capacitance of the capacitor 12 and R = an on-resistor R of CMOS inverter.

However, the on-resistor R of CMOS inverter is largely depended on a power supply voltage, a threshold value of CMOS inverter, and a temperature. Therefore, the oscillation frequency of the clock signal becomes unstable due to the variation of the power supply voltage, the threshold value of CMOS inverter, and the temperature.

In consideration of the above problem, the present invention has been made, and an object of the present invention is to reduce dependency of an oscillation frequency on a power supply voltage, a threshold value of CMOS inverter, and a temperature.

In order to attain the above object, according to the first aspect of the present invention, there is provided a ring oscillation circuit comprising $k$ number of CMOS inverters ($k$ = odd number) connected in a ring shape and a plurality of serial circuits connected between a connecting point of the respective CMOS inverters and a ground point. Each of the serial circuits comprises one MOS transistor and one capacitor which are connected to each other in series. A fixed voltage is applied to a gate of one MOS transistor of each of the serial circuits.

According to the second aspect of the present invention, there is provided a ring oscillation circuit comprising $k$ number of CMOS inverters ($k$ = odd number) connected in a ring shape, and a plurality of serial circuits connected between a connecting point of the respective CMOS inverters and a ground point. Each of the serial circuits comprises an N type MOS transistor and a P channel type MOS transistor connected in parallel with each other, and one capacitor connected between the N channel type MOS transistor or the P channel type MOS transistor and the ground point. A power supply voltage is applied to a gate of the N channel type MOS transistor, and a ground voltage is applied to a gate of the P channel type MOS transistor.

According to the third aspect of the present invention, there is provided a ring oscillation circuit comprising $k$ number of CMOS inverters ($k$ = odd number)) connected in a ring shape, a plurality of serial circuits connected between a connecting point of the respective CMOS inverters and a ground point. Each of the serial circuits comprises one MOS transistor and one capacitor connected to each other in series. The ring oscillation circuit further comprises a voltage generation circuit for supplying a fixed voltage to a gate of one MOS transistor of each of the serial circuits.

The voltage generation circuit comprises two resistor elements connected in series to each other, and a power supply voltage is applied to one end of the resistor and a ground voltage is applied to the other end.

According to the fourth aspect of the present invention, there is provided a ring oscillation circuit comprising $k$ number of CMOS inverters ($k$ = odd number) connected in a ring shape, a plurality of serial circuits connected between a connecting point of the respective CMOS inverters and a ground point. Each of the serial circuits comprises an N type MOS transistor and a P channel type MOS transistor connected in parallel with each other, and one capacitor connected between said N channel type MOS transistor or the P channel type MOS transistor and the ground point. The ring oscillation circuit further comprises a voltage generation circuit for supplying a fixed voltage to a gate of the N channel type MOS transistor and a gate of the P channel type MOS transistor.

The voltage generation circuit comprises two resistor elements connected in series to each other, and a power supply voltage is applied to one end of the resistor and a ground voltage is applied to the other end.

This invention can be more fully understood from the following detailed description when taken in conjunction with the accompanying drawings, in which:

FIG. 1 is a circuit diagram showing a conventional ring oscillation circuit;

FIG. 2 is a circuit diagram showing a ring oscillation circuit of a first embodiment of the present invention;

FIG. 3 is a circuit diagram showing one example of a CMOS inverter of FIG. 1;

FIG. 4 is a circuit diagram showing a ring oscillation circuit of a second embodiment of the present invention;

FIG. 5 is a circuit diagram showing a ring oscillation circuit of a third embodiment of the present invention;

FiG. 6 is a circuit diagram showing a ring oscillation circuit of a fourth embodiment of the present invention;

FIG. 7 is a circuit diagram showing a ring oscillation circuit of a fifth embodiment of the present invention; and

FIG. 8 is a circuit diagram showing a ring oscillation circuit of a sixth embodiment of the present invention.

Embodiments of the present invention will be explained with references to the drawings.

FIG. 2 is a circuit diagram showing a ring oscillation circuit of a first embodiment of the present invention. FIG. 3 specifically shows a CMOS inverter of FIG. 1.

The ring oscillation circuit comprises $\underline{k}$ number of CMOS inverters 11-1, 11-2, 11-3, 11-k ($k$ = odd number) connected in a ring shape, a serial circuit 13 connected between a connecting point of the respective CMOS inverters (excepting a connecting point between CMOS inverters 11-k and 11-1) and a ground point, and a voltage generation circuit 14 for supplying a fixed voltage to the series circuit 13.

Each CMOS inverter comprises a P channel type MOS transistor P1 in which a power supply voltage VCC is applied to a source and an input signal IN is supplied to a gate and an N channel type MOS transistor N1 in which a ground voltage VSS is applied to the source and the input signal IN is supplied to the gate.

An output signal OUT is outputted from a drain of the P channel type MOS transistor P1 and a drain of the N channel type MOS transistor N1.

The serial circuit 13 comprises an N channel type MOS transistor N2, which is connected in series between the connecting point of the CMOS inverters and the ground point, and a capacitor 12. The fixed voltage outputted from the voltage generation circuit 14 is supplied to a gate of the N channel type MOS transistor N2 of each of the serial circuit 13.

The voltage generation circuit 14 comprises resistor elements R1 and R2 which are connected in series between the power supply source and the ground point. The fixed voltage (R2 × VCC) / (R1 + R2) can be obtained from the connecting point between the resistor elements R1 and R2.

In the above-structured ring oscillation circuit, it is assumed that the on-resistance of the N channel type MOS transistor N2 is zero. Similar to the conventional ring oscillation circuit, the oscillation frequency of the clock signal is determined by a time constant C × R wherein C = capacitance of the capacitor 12 and R = an on-resistor R of CMOS inverter.

The on-resistor R of the CMOS inverter is varied, depending on the variation of the power supply voltage. The on-resistance of the N channel type MOS transistor N2 of the serial circuit 13 is also varied, depending on the variation of the power supply voltage.

Therefore, dependency of the constant time C × R on the power supply voltage VCC can be reduced, and the oscillation frequency of the clock signal can be stabilized.

For example, in a case where the power supply voltage VCC is lowered, the value R of the time constant C × R is increased by an increase in the on-resistance R of the CMOS inverter. At the same time, the value C of the time constant C × R is reduced by an increase in the on-resistance R of the N channel type MOS transistor N2.

As mentioned above, since an increase in the on-resistance R of the CMOS inverter is canceled by a decrease in the capacitor C, dependency of the constant time C × R on the power supply voltage VCC can be reduced, and the oscillation frequency of the clock signal can be stabilized.

Moreover, in a case that the threshold of the CMOS inverter is increased by the variation of the manufacturing process, the value R of the time constant C × R is increased by an increase in the on-resistance R of the CMOS inverter. At the same time, the value C of the time constant C × R is reduced by an increase in the on-resistance of the N channel type MOS transistor N2.

As mentioned above, since an increase in the on-resistance R of the CMOS inverter is canceled by a decrease in the capacitor C, dependency of the constant time C × R on the threshold of the CMOS inverter circuit can be reduced, and the oscillation frequency of the clock signal can be stabilized.

Moreover, in a case where the temperature is increased, the value R of the time constant C × R is increased by an increase in the on-resistance R of the CMOS inverter. At the same time, the value C of the time constant C × R is reduced by an increase in the on-resistance R of the N channel type MOS transistor N2.

As mentioned above, since an increase in the on-resistance R of the CMOS inverter is canceled by a decrease in the capacitor C, dependency of the constant time C × R on the temperature can be reduced, and the oscillation frequency of the clock signal can be stabilized.

The dependency of the oscillation frequency on the power supply voltage VCC, the threshold of the CMOS inverter, and the temperature is varied by a voltage division ratio of the voltage generation circuit 14 and a relative ratio of the input gate capacitance of the CMOS inverter to the capacitance of the capacitor.

Furthermore, the increase in the number of elements, a pattern area, and a consumption current due to addition of the N channel type MOS transistor N2 is small.

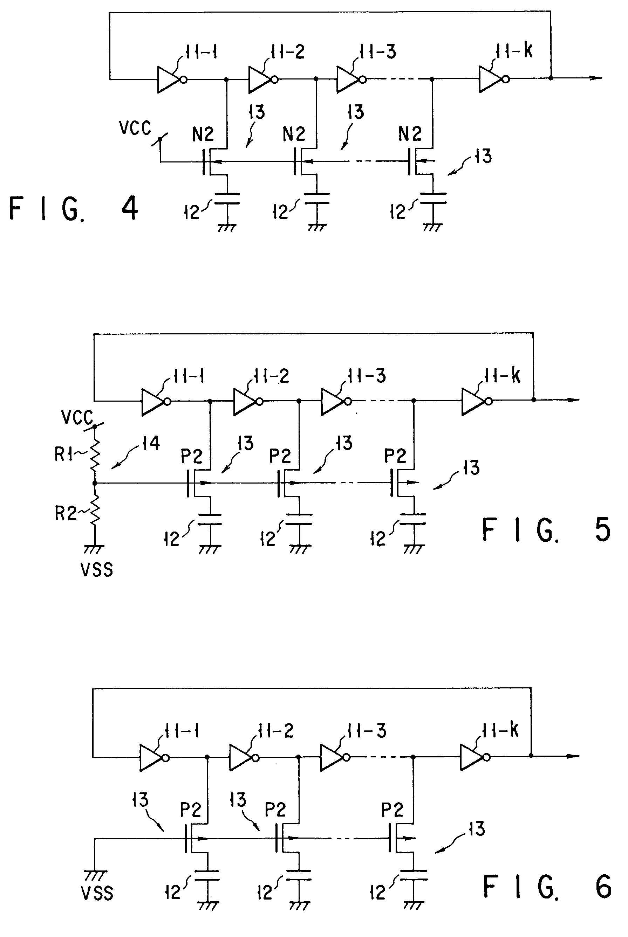

FIG. 4 shows a ring oscillation circuit of a second embodiment of the present invention.

The ring oscillation circuit comprises $\underline{k}$ number of CMOS inverters 11-1, 11-2, 11-3, 11-k ($k$ = odd number) connected in a ring shape, and the serial circuit 13 connected between the connecting point of the respective CMOS inverters (excepting a connecting point between CMOS inverters 11-k and 11-1) and the ground point.

As shown in FIG. 3, each CMOS inverter comprises the P channel type MOS transistor P1 in which the power supply voltage VCC is applied to the source and the input signal IN is supplied to the gate and theN channel type MOS transistor N1 in which the ground voltage VSS is applied to the source and the input signal IN is supplied to the gate.

The output signal OUT is outputted from the drain of the P channel type MOS transistor P1 and the drain of the N channel type MOS transistor N1.

The serial circuit 13 comprises the N channel type MOS transistor N2, which is connected in series between the connecting point of the CMOS inverters and the ground point, and the capacitor 12. The power supply voltage VCC is supplied to the gate of the N channel type MOS transistor N2 of each serial circuit 13.

The above-structured ring oscillation circuit differs from the ring oscillation circuit of FIG. 2 in the point that the power supply voltage VCC is supplied to the gate of the N channel type MOS transistor N2 of each serial circuit 13.

Even in the ring oscillation circuit of the above embodiment, the same advantage as the ring oscillation circuit of FIG. 2 can be obtained.

FIG. 5 shows a ring oscillation circuit of a third embodiment of the present invention.

The ring oscillation circuit comprises $\underline{k}$ number of CMOS inverters 11-1, 11-2, 11-3, 11-k ($k$ = odd number) connected in a ring shape, the serial circuit 13 connected between a connecting point of the respective CMOS inverters (excepting a connecting point between CMOS inverters 11-k and 11-1) and a ground point, and the voltage generation circuit 14 for supplying a fixed voltage to the series circuit 13.

As shown in FIG. 3, each CMOS inverter comprises the P channel type MOS transistor P1 in which the power supply voltage VCC is applied to the source and the input signal IN is supplied to the gate and the N channel type MOS transistor N1 in which the ground voltage VSS is applied to the source and the input signal IN is supplied to the gate.

The output signal OUT is outputted from the drain of the P channel type MOS transistor P1 and the drain of the N channel type MOS transistor N1.

The serial circuit 13 comprises a P channel type MOS transistor P2, which is connected in series between the connecting point of the CMOS inverters and the ground point, and the capacitor 12. The fixed voltage outputted from the voltage generation circuit 14 is supplied to a gate of the P channel type MOS transistor P2 of each of the serial circuit 13. The voltage generation circuit 14 comprises resistor elements R1 and R2, which are connected in series between the power supply source and the ground point. The fixed voltage (R2 × VCC) / (R1 + R2) can be obtained from the connecting point between the resistor elements R1 and R2.

The above-structured ring oscillation circuit differs from the ring oscillation circuit of FIG. 2 in the point that the serial circuit 13 comprises the P channel type MOS transistor P2 and the capacitor 12.

Even in the ring oscillation circuit of the above embodiment, the same advantage as the ring oscillation circuit of FIG. 2 can be obtained.

FIG. 6 shows a ring oscillation circuit of a fourth embodiment of the present invention.

The ring oscillation circuit comprises $\underline{k}$ number of CMOS inverters 11-1, 11-2, 11-3, 11-k ($k$ = odd number) connected in a ring shape, and the serial circuit 13 connected between the connecting point of the respective CMOS inverters (excepting a connecting point between CMOS inverters 11-k and 11-1) and the ground point.

As shown in FIG. 3, each CMOS inverter comprises the P channel type MOS transistor P1 in which the power supply voltage VCC is applied to the source and the input signal IN is supplied to the gate and theN channel type MOS transistor N1 in which the ground voltage VSS is applied to the source and the input signal IN is supplied to the gate.

The output signal OUT is outputted from the drain of the P channel type MOS transistor P1 and the drain of the N channel type MOS transistor N1.

The serial circuit 13 comprises the P channel type MOS transistor P2, which is connected in series between the connecting point of the CMOS inverters and the ground point, and the capacitor 12. A ground voltage VSS is supplied to the gate of the P channel type MOS transistor P2 of each serial circuit 13.

The above-structured ring oscillation circuit differs from the ring oscillation circuit of FIG. 2 in the point that the serial circuit 13 comprises the P channel type MOS transistor P2 and the capacitor 12 and the ground voltage VSS is supplied to the gate of the P channel type MOS transistor of each serial circuit 13.

Even in the ring oscillation circuit of the above embodiment, the same advantage as the ring oscillation circuit of FIG. 2 can be obtained.

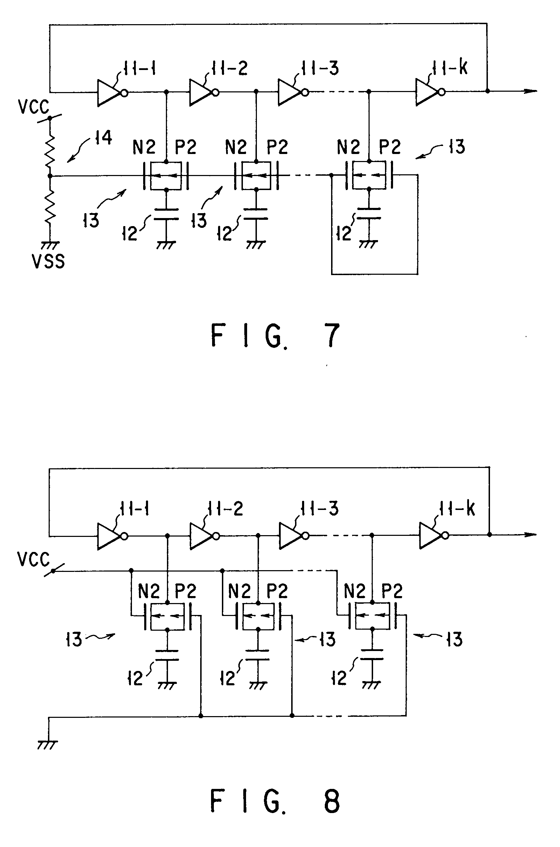

FIG. 7 shows a ring oscillation circuit of a fifth embodiment of the present invention.

The ring oscillation circuit comprises k number of CMOS inverters 11-1, 11-2, 11-3, 11-k (k = odd number) connected in a ring shape, the serial circuit 13 connected between a connecting point of the respective CMOS inverters (excepting a connecting point between CMOS inverters 11-k and 11-1) and a ground point, and the voltage generation circuit 14 for supplying a fixed voltage to the series circuit 13.

As shown in FIG. 3, each CMOS inverter comprises the P channel type MOS transistor P1 in which the power supply voltage VCC is applied to the source and the input signal IN is supplied to the gate and the N channel type MOS transistor N1 in which the ground voltage VSS is applied to the source and the input signal IN is supplied to the gate.

The output signal OUT is outputted from the drain of the P channel type MOS transistor P1 and the drain of the N channel type MOS transistor N1.

The serial circuit 13 comprises a MOS transistor, which is connected in series between the connecting point of the CMOS inverters and the ground point, and the capacitor. Each CMOS transistor comprises a P channel type MOS transistor P2, and an N channel type MOS transistor N2. The P channel type MOS transistor P2 is connected in parallel with the N channel type MOS transistor N2.

The fixed voltage outputted from the voltage generation circuit 14 is supplied to a gate of the P channel type MOS transistor P2 of each of the serial circuit 13 and a gate of the N channel type MOS transistor N2.

The voltage generation circuit 14 comprises resistor elements R1 and R2, which are connected in series between the power supply source and the ground point. The fixed voltage (R2 × VCC) / (R1 + R2) can be obtained from the connecting point between the resistor elements R1 and R2.

The above-structured ring oscillation circuit differs from the ring oscillation circuit of FIG. 2 in the point that the P channel type MOS transistor P2 is connected in parallel with the N channel type MOS transistor N2.

Even in the ring oscillation circuit of the above embodiment, the same advantage as the ring oscillation circuit of FIG. 2 can be obtained.

FIG. 8 shows a ring oscillation circuit of a sixth embodiment of the present invention.

The ring oscillation circuit comprises k number of CMOS inverters 11-1, 11-2, 11-3, 11-k (k = odd number) connected in a ring shape, and the serial circuit 13 connected between a connecting point of the respective CMOS inverters (excepting a connecting point between CMOS inverters 11-k and 11-1) and a ground point.

As shown in FIG. 3, each CMOS inverter comprises the P channel type MOS transistor P1 in which the power supply voltage VCC is applied to the source and the input signal IN is supplied to the gate and the N channel type MOS transistor N1 in which the ground voltage VSS is applied to the source and the input signal IN is supplied to the gate.

The output signal OUT is outputted from the drain of the P channel type MOS transistor P1 and the drain of the N channel type MOS transistor N1.

The serial circuit 13 comprises a MOS transistor, which is connected in series between the connecting point of the CMOS inverters and the ground point, and the capacitor. Each CMOS transistor comprises the P channel type MOS transistor P2, and the N channel type MOS transistor N2. The P channel type MOS transistor P2 is connected in parallel with the N channel type MOS transistor N2.

The power supply voltage VCC is supplied to the gate of the N channel type MOS transistor N2 of each serial circuit 13. The ground voltage VSS is supplied to the gate of the P channel type MOS transistor P2 of each serial circuit 13.

The above-structured ring oscillation circuit differs from the ring oscillation circuit of FIG. 2 in the following points.

More specifically, the P channel type MOS transistor P2 is connected in parallel with the N channel type MOS transistor N2. And, the power supply voltage VCC is supplied to the gate of the N channel type MOS transistor N2 of each serial circuit 13. The ground voltage VSS is supplied to the gate of the P channel type MOS transistor P2 of each serial circuit 13.

Even in the ring oscillation circuit of the above embodiment, the same advantage as the ring oscillation circuit of FIG. 2 can be obtained.

**Claims**

1. A ring oscillation circuit characterized by comprising:

k number of CMOS inverters (11-1, 11-2, 11-3, 11-k (k = odd number)) connected in a ring shape; and

a plurality of serial circuits (13) connected between a connecting point of said respective CMOS inverters and a ground point, wherein each of said serial circuits (13) comprises one MOS transistor (N2, P2) and one capacitor (12) connected to each other in series, and a fixed voltage is applied to a gate of one MOS transistor (N2, P2) of each of said serial circuits (13).

2. A ring oscillation circuit according to claim 1, characterized in that one MOS transistor of each of said serial circuits (13) is an N channel type MOS transistor (N2), and said fixed voltage is a power supply voltage.

3. A ring oscillation circuit according to claim 1, characterized in that one MOS transistor of each of said serial circuits (13) is a P channel type MOS transistor (P2), and said fixed voltage is a ground voltage.

4. A ring oscillation circuit according to claim 1, characterized in that an on-resistance of said CMOS inverter is varied, depending on the variation of the power supply voltage, that of a threshold value of said CMOS inverter, or that of a temperature, and an on-resistance of one MOS transistor of each of said serial circuits is also varied, depending on the the variation of the power supply voltage, that of the threshold value of said CMOS inverter, or that of the temperature.

5. A ring oscillation circuit characterized by comprising:

k number of CMOS inverters (11-1, 11-2, 11-3, 11-k (k = odd number)) connected in a ring shape; and

a plurality of serial circuits (13) connected between a connecting point of said respective CMOS inverters and a ground point, wherein each of said serial circuits (13) comprises an N type MOS transistor (N2) and a P channel type MOS transistor (P2) connected in parallel with each other, and one capacitor (12) connected between said N channel type MOS transistor or the P channel type MOS transistor and the ground point; and a power supply voltage is applied to a gate of said N channel type MOS transistor (N2); and a ground voltage is applied to a gate of said P channel type MOS transistor (P2).

6. A ring oscillation circuit according to claim 5, characterized in that an on-resistance of said CMOS inverter is varied, depending on the variation of the power supply voltage, that of a threshold value of said CMOS inverter, or that of a temperature, and an on-resistance of said N channel type MOS transistor and that of said P channel type MOS transistor are also varied, depending on the the variation of the power supply voltage, that of the threshold value of said CMOS inverter, or that of the temperature.

7. A ring oscillation circuit characterized by comprising:

k number of CMOS inverters (11-1, 11-2, 11-3, 11-k (k = odd number)) connected in a ring shape;

a plurality of serial circuits (13) connected between a connecting point of said respective CMOS inverters and a ground point, wherein each of said serial circuits (13) comprises one MOS transistor (N2, P2) and one capacitor (12) connected to each other in series; and

a voltage generation circuit (14) for supplying a fixed voltage to a gate of one MOS transistor (N2, P2) of each of said serial circuit (13).

8. A ring oscillation circuit according to claim 7, characterized that said voltage generation circuit (14) comprises two resistor elements (R1, R2) connected in series to each other, and a power supply voltage is applied to one end of said resistor and a ground voltage is applied to the other end.

9. A ring oscillation circuit according to claim 7, characterized in that one MOS transistor of each of said serial circuits (13) is an N channel type MOS transistor (N2).

10. A ring oscillation circuit according to claim 7, characterized in that one MOS transistor of each of said serial circuits (13) is a P channel type MOS transistor (P2).

11. A ring oscillation circuit according to claim 7, characterized in that an on-resistance of said CMOS inverter is varied, depending on the variation of the power supply voltage, that of a threshold value of said CMOS inverter, or that of a temperature, and an on-resistance of one MOS transistor of each of said serial circuits is also varied, depending on the the variation of the power supply voltage, that of the threshold value of said CMOS inverter, or that of the temperature.

12. A ring oscillation circuit characterized by comprising:

k number of CMOS inverters (11-1, 11-2, 11-3, 11-k (k = odd number)) connected in a ring shape;

a plurality of serial circuits (13) connected between a connecting point of said respective CMOS inverters and a ground point, wherein each of said serial circuits (13) comprises an N type MOS transistor (N2) and a P channel type MOS transistor (P2) connected in parallel with each other, and one capacitor (12) connected between said N channel type MOS transistor or the P channel type MOS transistor and the ground point; and

a voltage generation circuit (14) for supplying a fixed voltage to a gate of said N channel type MOS transistor (N2) and a gate of said P channel type MOS transistor (P2).

13. A ring oscillation circuit according to claim 12, characterized in that said voltage generation circuit (14) comprises two resistor elements (R1, R2) connected in series to each other, and a power supply voltage is applied to one end of said resistor and a ground voltage is applied to the other end.

14. A ring oscillation circuit according to claim 12, characterized in that an on-resistance of said CMOS inverter is varied, depending on the variation of the power supply voltage, that of a threshold value of said CMOS inverter, or that of a temperature, and an on-resistance of said N channel type MOS transistor and that of said P channel type MOS transistor are also varied, depending on the the variation of the power supply voltage, that of the threshold value of said CMOS inverter, or that of the temperature.

F I G. 1

F I G. 2

F I G. 3

F I G. 4

F I G. 5

F I G. 6

F I G. 7

F I G. 8

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-5 036 216 (J. W. HOHMANN ET AL) *Figure 2, elements 225, 235; column 6, lines 26 - 38; column 7, line 9 - column 8, line 6* | 1,7,10 | H03K3/03 H03K3/354 H03K3/011 |
| A | --- | 5,12 | |
| X | US-A-4 656 369 (P. W. LOU) * figure 5 * | 1,7 | |
| A | EP-A-0 383 549 (ICT INTERNATIONAL CMOS TECHNOLOGY, INC.) * abstract; figure 3 * | 1,5,7,12 | |
| A | EP-A-0 304 975 (N. V. PHILIPS' GLOEILAMPENFABRIEKEN) * abstract; figure 2 * | 1,5,7,12 | |
| A | EP-A-0 254 212 (KABUSHIKI KAISHA TOSHIBA) * figures 1-8 * | 1,5,7,12 | |
| A | US-A-4 547 749 (C. C. K. KUO) * the whole document * | 1,5,7,12 | TECHNICAL FIELDS SEARCHED (Int.Cl.6) H03K |

The present search report has been drawn up for all claims

| Place of search | Date of completion of the search | Examiner |
|---|---|---|
| BERLIN | 31 March 1995 | Arendt, M |

EPO FORM 1503 03.82 (P04C01)